# EUROPÄISCHE PATENTSCHRIFT

(11) **EP 0 577 094 B1**
(45) Veröffentlichungstag und Bekanntmachung des Hinweises auf die Patenterteilung: **05.02.1997**
(21) Anmeldenummer: 93110423.6
(22) Anmeldetag: 30.06.1993
(51) Int. Cl.: H05K 3/28, B29C 63/22, B32B 31/00

(54) **Schutzüberzug für elektronische Baugruppen, sowie Verfahren zu dessen Herstellung**
Protective covering for printed circuit boards and method for their manufacture
Enveloppe protectrice pour cartes de circuits imprimés et procédé pour sa fabrication

(30) Priorität: 30.06.1992 CH 2044/92
(43) Veröffentlichungstag der Anmeldung: 05.01.1994
(73) Patentinhaber: CERBERUS AG, CH-8708 Männedorf (CH)
(72) Erfinder: Hidber, Arthur, CH-8133 Esslingen (CH); Ryser, Eduard, CH-8610 Uster (CH)

(56) Entgegenhaltungen:
- EP-A- 0 329 172
- EP-A- 0 341 188
- DE-B- 1 182 319
- US-A- 4 949 610
- PATENT ABSTRACTS OF JAPAN, Bd. 10, Nr. 72 (P-438)22.März 1986;& JP-A-60209884
- PATENT ABSTRACTS OF JAPAN, Bd. 13, Nr. 473 (M-884)26.Oktober 1989;& JP-A-1186316

## Beschreibung

Die Erfindung betrifft eine Leiterplatte für elektronische Baugruppen mit einem Schutzüberzug aus einem elektrisch isolierenden, thermoplastischen Material sowie ein Verfahren zur Herstellung einer solchen Leiterplatte mit Schutzüberzug.

Solche Leiterplatten mit Schutzüberzügen sind z.B. aus der Publikation von James J. Licari "Plastic Coatings for Electronics", McGraw-Hill Book Company, New York, bekannt. Sie dienen dem Schutz elektronischer Baugruppen auf den Leiterplatten vor Feuchtigkeit und anderen Umgebungseinflüssen, sowie vor Verschmutzungen, welche eine Korrosion gewisser Bauteile und damit eine Änderung der Eigenschaften, und eine Herabsetzung des Isolationswiderstandes zwischen den Leiterbahnen der gedruckten Schaltung oder den Anschlüssen von Bauelementen bewirken könnten.

Bekannte Schutzüberzüge dieser Art werden in der Regel durch Tauchen, Vergiessen, Lakkieren, Aufsprühen oder Aufstreichen einer geeigneten Kunststoffmasse oder eines Kunstharzes hergestellt. Hierbei ist nachteilig, dass sehr lange Trocken- und Aushärtezeiten erforderlich sind, dass praktisch keine gleichmässige Abdeckung möglich ist, dass insbesondere scharfe Kanten und Spitzen nur schwierig hinreichend abdeckbar sind, was Mehrfachbeschichtungen und ein Wenden der Leiterplatten während des Trockenvorgangs nötig macht, dass aufwendige Dosiervorrichtungen benötigt werden, die einen aufwendigen Unterhalt und eine häufige Reinigung nötig machen, dass eine exakte Freistellung bestimmter Komponenten schwierig ist, und dass sich mit diesen bekannten Verfahren keine porenfreien und hinreichend dichten Überzüge gleichmässiger Dichte erzielen lassen.

In der JP-A-60 209 884 (Toshiba KK; vgl. Patent Abstracts of Japan, Vol. 10, No. 72) wurde vorgeschlagen, zur Verbesserung der Zuverlässigkeit von elektrischen Verbindungen bei gedruckten Schaltungen auf die Leiterplatten eine Vorder- und eine Rückseiten-Trägerschicht aus thermoplastischem Material, z.B. aus Polyvinylchlorid oder dergleichen, aufzubringen, und die beiden Schichten durch Aufschmelzen mit den Leiterplatten zu IC-Karten zu verbinden. Dieses Verfahren hat den Nachteil, dass die so abgedeckten elektrischen Schaltungen nach der Einsiegelung nicht mehr zugänglich sind. Das heisst, es können nach Fertigstellung der IC-Karten keine Messungen mehr an den einzelnen Schaltungsteilen durchgeführt, und es können keine Baugruppen nachträglich ausgewechselt werden.

Aus der EP-A-0 341 188 sind Kunststoffolien aus einem thermoplastischen Kunststoff (z.B. Polypropylen) bekannt, denen ein gewisser Anteil Wachs zugesetzt ist. Diese Folien, die zur Verpackung bestimmter Waren, wie beispielsweise Esswaren, verwendet werden, wirken als Schutz gegen Feuchtigkeit, Sauerstoff und Geruch.

Von diesem Stand der Technik ausgehend hat sich die Erfindung die Aufgabe gestellt, eine Leiterplatte mit einem Schutzüberzug der eingangs genannten Art zu schaffen, deren Schutzüberzug die genannten Nachteile des Standes der Technik nicht aufweist. Insbesondere soll sich der Schutzüberzug in kürzester Zeit mit einem einfachen Verfahren und mit unterhaltsarmen Vorrichtungen mit gleichmässiger Schichtdicke und mit praktisch vollständiger Luft- und Flüssigkeitsundurchlässigkeit auf allen Teilen der Leiterplatte unter exakter Freistellung bestimmter Komponenten aufbringen lassen. Eine weitere Aufgabe der Erfindung besteht darin, den Schutzüberzug so auszubilden, dass während der ganzen Lebensdauer der Leiterplatten einzelne Schaltelemente durch den Schutzüberzug hindurch gemessen, und einzelne Bauteile auch nach Fertigstellung des Schutzüberzugs ausgewechselt werden können.

Eine Aufgabe der vorliegenden Erfindung besteht insbesondere auch darin, eine Automatisierung und ein Aufbringen der Schutzüberzüge auf die Leiterplatten mit einer kurzen Taktfolge und damit eine rationelle Produktion zu ermöglichen.

Die erfindungsgemässe Leiterplatte mit einem Schutzüberzug zur Lösung dieser Aufgaben ist dadurch gekennzeichnet, dass der Schutzüberzug aus einer Kunststoffolie aus elektrisch isolierendem, thermoplastischem Material besteht, dem zur Verbesserung seiner Fliesseigenschaften ein Wachs beigemischt ist, welches gleichzeitig die Durchkontaktierung und die Durchführung von Lötungen durch den Schutzüberzug ermöglicht, und dass die geometrische Form der Kunststoffolie der zu schützenden Fläche der Leiterplatte entspricht, und die Folie mittels Temperatureinwirkung auf die Leiterplatte aufgeschmolzen ist, so dass sie die Leiterplatte praktisch luftdicht und feuchtigkeitsdicht abdeckt.

Gemäss einer bevorzugten Ausführungsform der erfindungsgemässen Leiterplatte mit Schutzüberzug besteht die Kunststoffolie aus einem Gemisch eines ersten Bestandteils aus Polypropylen, Hydrocarbonharz, Styrol-Butadien-Polymer, Paraffinwachs und Polyethylen und eines zweiten Bestandteils aus einem Wachs mit einem erheblichen Anteil an verzweigtkettigen und cycloalophatischen Kohlenwasserstoffen. Vorzugsweise besteht die Kunststofffolie aus einem Gemisch von 9 bis 3 Teilen, vorzugsweise von 7 Teilen, des ersten Bestandteils und von 1 bis 7 Teilen, vorzugsweise von 3 Teilen, des zweiten Bestandteils.

Gemäss einer weiteren bevorzugten Ausführungsform weist die Kunststoffolie Öffnungen für auf der Leiterplatte freizustellende Komponenten auf und hat einen Schmelzbereich von 120° - 170°C.

Das erfindungsgemässe Verfahren zur Herstellung dieser Leiterplatte mit Schutzüberzug ist dadurch gekennzeichnet, dass die Kunststoffolie in einem ersten Verfahrensschritt in die der zu schützenden Fläche der Leiterplatte entsprechende geometrische Form gebracht, in einem anschliessenden Schritt auf die Oberfläche der Leiterplatte aufgebracht, und in einem letzten Schritt unter Wärmeeinwirkung auf die Leiterplatte aufgeschmolzen wird.

Vorzugsweise wird in einem dem ersten Verfahrensschritt vorangehenden Verfahrensschritt durch Ausgiessen eines geschmolzenen Ausgangsmaterials auf eine Unterlage oder durch Ausgiessen eines geschmolzenen Ausgangsmaterials und Ausziehen zwischen parallelen Walzen ein Trägerband hergestellt. Aus dem Trägerband wird dann die Kunststoffolie ausgestanzt.

Nach einem besonders bevorzugten Verfahren wird die Kunststoffolie aus dem Trägerband durch Wasserstrahlschneiden gebildet, nach Positionierung auf der Leiterplatte durch Erwärmung in einen plastischen Zustand gebracht und mittels eines Silikontampons auf die elektronischen Baugruppen gedrückt, so dass eine eng anliegende Topographie entsteht und vorhandene Luftreste verdrängt werden, und es wird in einem abschliessenden Verfahrensschritt der Schutzüberzug unter weiterer Wärmeeinwirkung auf die Leiterplatte aufgeschmolzen.

Im folgenden wird die Erfindung anhand eines Ausführungsbeispiels und der Zeichnungen näher erläutert; es zeigt:

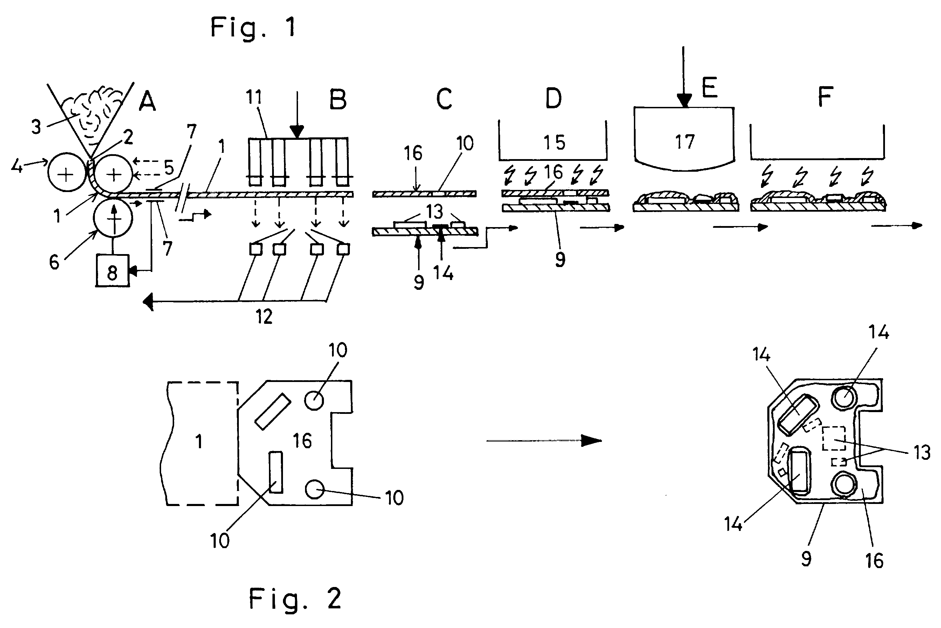

- Fig. 1: eine schematische Seitenansicht einer Anlage zur Herstellung eines Schutzüberzuges auf einer Leiterplatte mit den einzelnen Verfahrensschritten; und
- Fig. 2: einen Teil der Herstellungs-Anlage von Fig. 1 in einer schematischen Draufsicht.

Bei der dargestellten Anlage wird zuerst in einem Verfahrensschritt A ein Trägerband 1 aus einem geeigneten Rohmaterial hergestellt. Als Ausgangsmaterial dient dazu ein Gemisch aus einem ersten Bestandteil aus Polypropylen, Hydrocarbonharz, Styrol-Butadien-Polymer, Paraffinwachs und Polyethylen, das unter der Bezeichnung "Jet-Melt" 3748" von 3M erhältlich ist, und dem zur Verbesserung der Fliesseigenschaften ein zweiter Bestandteil aus einem Wachs mit einem erheblichen Anteil von verzweigtkettigen und cycloaliphatischen Kohlenwasserstoffen zugesetzt ist. Das Wachs kann z.B. unter der Bezeichnung "Lunarit 3286" von der Firma H.B.Fuller in Lüneburg, Deutschland, bezogen werden.

Für die Herstellung des Ausgangsmaterials werden die Bestandteile in einem geeigneten Verhältnis, das von der geplanten Verwendung abhängt, miteinander gemischt. Am besten bewährt hat sich ein Material, das eine Erweichungstemperatur von über 100°C oder einen Schmelzbereich von 120 bis 170°C aufweist und das beim Erstarren auf der Leiterplatte 9 einen porenfreien und luft- und flüssigkeitsundurchlässigen Überzug bildet. Das Material selbst muß einerseits schädlichen Umgebungseinflüssen und der Verschmutzung widerstehen und eine gewisse Temperaturfestigkeit ohne wesentliche Eigenschaftsveränderungen und eine genügende Alterungsbeständigkeit aufweisen; andererseits muß es aber auch mit den zu überziehenden Bauteilen verträglich sein und die Eigenschaften der Baugruppen nicht in unzulässiger Weise verändern. Ein bevorzugtes Material besteht aus einer Mischung von 70 kg Jet-Melt 3748 und 30 kg Lunarit.

In einem üblichen heizbaren Mischer werden die Bestandteile des Ausgangsmaterials miteinander gemischt und auf die Verarbeitungstemperatur erhitzt. Die flüssige Rohmasse 2 fließt aus einem Extruder 3 in den Spalt zwischen zwei auf die Erstarrungstemperatur des Kunststoffs gekühlte Kühlwalzen 4, 5, erstarrt dort zu einer zunächst noch formbaren Folienbahn 1, welche mittels einer Preßwalze 6 auf die gewünschte Foliendicke gebracht wird. Dabei können die Walzen durch Silikonpapier geschützt werden. Die Foliendicke kann dabei mittels einer Dickenmeßvorrichtung 7 und einer Regeleinrichtung 8 durch Steuerung der Preßkraft der Preßwalze 6 auf einen konstanten Wert geregelt werden. Nach dem Verlassen der Preßwalze 6 kühlt die Folienbahn 1 ab und verläßt den Anlagenteil A als kontinuierliches Trägerband, welches als Ausgangsmaterial für den Schutzüberzug 16 dient.

Statt mit einem kontinuierlichen Herstellungsverfahren kann die Folie aber auch einzeln oder taktweise produziert werden, indem z.B. eine bestimmte Menge an geschmolzenem Kunststoffmaterial in einer Presse abgekühlt und dabei auf ein bestimmte Dicke gebracht wird oder indem das geschmolzene Ausgangsmaterial 2 auf eine Unterlage gegossen wird. Dies kann auch kontinuierlich geschehen, indem durch Steuerung des Materialzuflusses und der Fortbewegung der Unterlage die Schichtdicke des Trägerbandes eingestellt wird.

Die Foliendicke wird so gewählt, daß Unebenheiten auf der Leiterbahn und insbesondere Lötspitzen sicher überdeckt werden, ohne daß die Folie beim Aufschmelzen aufreißt. Meist genügt dabei eine Foliendicke von etwa 0,2 bis 1,0 mm. Für spezielle Anwendungen, z.B. zum Schutz von Leiterplatten 9, welche herausragende Bauteile oder scharfe Spitzen aufweisen, können auch dickere Folien, z.B. von mehreren Millimetern Dicke, verwendet werden.

Das im Verfahrensschritt A hergestellte Trägerband 1 kann auf eine Rolle aufgewickelt und für die weitere Verwendung bereitgehalten werden, oder es kann unmittelbar anschließend schrittweise in einem bestimmten Zeittakt dem folgenden Verfahrensschritt B zugeführt werden. Hier wird die Folie 1 in die der zu schützenden Leiterplatte 9 entsprechende geometrische Form gebracht.

Dies kann durch Zuschneiden der Folie geschehen oder vorteilhafterweise durch Ausstanzen der äußeren Form und der nötigen Öffnungen 10 für auf der Leiterplatte 9 freizustellende Komponenten. Dazu kann eine taktweise arbeitende Stanzvorrichtung 11 verwendet werden, deren Stanzeinsatz bei Umstellung auf andere zu schützende Leiterplatten ausgetauscht werden kann. Der Stanzabfall 12 kann hierbei problemlos durch Einschmelzen im Extruder 3 wiederverwendet werden, so daß keinerlei Entsorgungsprobleme entstehen.

Im daraufolgenden Verfahrensschritt C wird die derart vorbearbeitete Folie 16 auf die bereits mit Bauelementen bestückte Leiterplatte 9 aufgebracht. Zu schützende Baugruppen 13 werden dabei von der Folie 16 abgedeckt, während freizustellende Komponenten 14 in die Folienöffnungen 10 zu liegen kommen.

Anschließend wird im Verfahrensschritt D die Folie 16 auf eine Temperatur oberhalb des Erweichungspunktes erhitzt, ohne daß sie jedoch schmilzt. Die so erweichte Folie 16 wird im Verfahrensschritt E mittels eines Weichsilikontampons 17 über die elektronischen Bauteile gedrückt, wobei die Folie 16 in engen Kontakt mit den Bauteilen kommt, so daß restliche Luft verdrängt wird. In einem abschließenden Verfahrensschritt F wird der Schutzüberzug 16 unter weiterer Wärmeeinwirkung auf die Leiterplatte 9 aufgeschmolzen. Dies kann vorteilhafterweise mittels einer oberhalb der Folie 16 angeordneten Infrarotstrahlungsheizung 15 erfolgen oder in anderer Weise, z.B. mittels Heißluft oder einem heißen Inertgas.

Der so auf der Leiterplatte 9 gebildete Schutzüberzug 16 bedeckt die zu schützenden Baugruppen 13, insbesondere auch Unebenheiten und Spitzen derselben, mit einer luft- und flüssigkeitsundurchlässigen Schicht gleichmäßiger Dicke und schützt sie zuverlässig gegen Umgebungseinflüsse. Dabei sind partielle Freistellungen, z.B. für Schalter, Potentiometer, Prüfpunkte und dergleichen, ohne Aufwand und Schwierigkeiten zu erreichen.

Ein solcher Schutzüberzug läßt sich zudem mit einem einfachen und leicht automatisierbaren Herstellungsverfahren ohne großen Aufwand und mit kurzer Taktfolge, d.h. rationell und kostengünstig in großer Stückzahl produzieren.

Abwandlungen des vorbeschriebenen Schutzüberzugs und des Verfahrens zu seiner Herstellung sind im Rahmen der Erfindung gemäß den Ansprüchen möglich und dem Fachmann geläufig.

### Bezugszeichen

### Bezugszeichen - Reference numbers

- Trägerband (Folienbahn): 1
- Rohmasse: 2
- Extruder: 3
- Kühlwalze: 4
- Kühlwalze: 5
- Preßwalze: 6
- Dickenmeßvorrichtung: 7
- Regeleinrichtung: 8
- Leiterplatte: 9
- Öffnungen: 10
- Stanzvorrichtung: 11
- Stanzabfall: 12
- Baugruppen: 13
- freizustellende Komponenten: 14
- Infrarotstrahlungsheizung: 15
- Schutzüberzug (Folie): 16
- Weichsilikontampon: 17

## Patentansprüche

1. Leiterplatte für elektronische Baugruppen mit einem Schutzüberzug aus einem elektrisch isolierenden, thermoplastischen Material, wobei der Schutzüberzug aus einer Kunststofffolie (16) aus elektrisch isolierendem, thermoplastischem Material besteht, dem zur Verbesserung seiner Fliesseigenschaften ein Wachs beigemischt ist, welches gleichzeitig die Durchkontaktierung und die Durchführung von Lötungen durch den Schutzüberzug ermöglicht, und dass die geometrische Form der Kunststoffolie der zu schützenden Fläche der Leiterplatte (9) entspricht, und die Folie mittels Temperatureinwirkung auf die Leiterplatte aufgeschmolzen ist, so dass sie die Leiterplatte praktisch luftdicht und feuchtigkeitsdicht abdeckt.

2. Leiterplatte mit Schutzüberzug nach Anspruch 1, dadurch gekennzeichnet, dass die Kunststoffolie (16) aus einem Gemisch eines ersten Bestandteils aus Polypropylen, Hydrocarbonharz, Styrol-Butadien-Polymer, Paraffinwachs und Polyethylen und eines zweiten Bestandteils aus einem Wachs mit einem erheblichen Anteil an verzweigtkettigen und cycloaliphatischen Kohlenwasserstoffen besteht.

3. Leiterplatte mit Schutzüberzug nach Anspruch 2, dadurch gekennzeichnet, dass die Kunststoffolie (16) aus einem Gemisch von 9 bis 3 Teilen, vorzugsweise von 7 Teilen, des ersten Bestandteils und von 1 bis 7 Teilen, vorzugsweise von 3 Teilen, des zweiten Bestandteils besteht.

4. Leiterplatte mit Schutzüberzug nach einem der Ansprüche 1 bis 3, dadurch gekennzeichnet, dass die Kunststoffolie (16) Öffnungen (10) für auf der Leiterplatte (9) freizustellende Komponenten (14) aufweist.

5. Leiterplatte mit Schutzüberzug nach einem der Ansprüche 1 bis 4, dadurch gekennzeichnet, dass die Kunststoffolie (16) einen Schmelzbereich von 120° - 170°C aufweist.

6. Verfahren zur Herstellung einer Leiterplatte mit Schutzüberzug nach einem der Ansprüche 1 bis 5, bei welchem die Kunststoffolie (16) in einem ersten Verfahrensschritt (B) in die der zu schützenden Fläche der Leiterplatte (9) entsprechende geometrische Form gebracht, in einem anschliessenden Schritt (C) auf die Oberfläche der Leiterplatte aufgebracht, und in einem letzten Schritt (D) unter Wärmeeinwirkung auf die Leiterplatte aufgeschmolzen wird.

7. Verfahren nach Anspruch 6, dadurch gekennzeichnet, dass die Kunststoffolie aus einem in einem dem ersten Verfahrensschritt (B) vorangehenden Verfahrensschritt (A) durch Ausgiessen eines geschmolzenen Ausgangsmaterials (2) auf eine Unterlage gebildeten Trägerband (1) hergestellt wird.

8. Verfahren nach Anspruch 6, dadurch gekennzeichnet, dass die Kunststoffolie aus einem in einem dem ersten Verfahrensschritt (B) vorangehenden Verfahrensschritt (A) durch Ausgiessen eines geschmolzenen Ausgangsmaterials (2) und Ausziehen zwischen parallelen Walzen (5, 6) gebildeten Trägerband (1) hergestellt wird.

9. Verfahren nach Anspruch 7 oder 8, dadurch gekennzeichnet, dass die Kunststoffolie (16) aus dem Trägerband (1) ausgestanzt wird.

10. Verfahren nach Anspruch 7 oder 8, dadurch gekennzeichnet, dass die Kunststoffolie (16) aus dem Trägerband (1) durch Wasserstrahlschneiden gebildet, nach Positionierung auf der Leiterplatte (9) durch Erwärmung in einen plastischen Zustand gebracht und mittels eines Silikontampons (17) auf die elektronischen Baugruppen (13) gedrückt wird, so dass eine eng anliegende Topographie entsteht und vorhandene Luftreste verdrängt werden, und dass in einem abschliessenden Verfahrensschritt der Schutzüberzug (16) unter weiterer Wärmeeinwirkung auf die Leiterplatte (9) aufgeschmolzen wird.

## Claims

1. Printed circuit board for electronic modules, having a protective coating made from an electrically insulating, thermoplastic material, the protective coating consisting of a plastic film (16) made from an electrically insulating, thermoplastic material to which a wax is added to improve its flow properties, said wax at the same time facilitating through-plating and soldering operations through the protective coating, and the geometrical shape of the plastic film corresponds to the area of the printed circuit board (9) to be protected, and the film is fused onto the printed circuit board by the action of heat, so that it covers the printed circuit board in a virtually air-tight and moisture-proof manner.

2. Printed circuit board with protective coating according to Claim 1, **characterised in that** the plastic film (16) consists of a mixture of a first component comprised of polypropylene, hydrocarbon resin, styrene-butadien polymer, paraffin wax and polyethylene, and a second component comprised of a wax with a substantial proportion of branched-chain and cyclo-aliphatic hydrocarbons.

3. Printed circuit board with protective coating according to Claim 2, **characterised in that** the plastic film (16) consists of a mixture of 9 to 3 parts, preferably 7 parts, of the first component and of 1 to 7 parts, preferably 3 parts, of the second component.

4. Printed circuit board with protective coating according to one of Claims 1 to 3, **characterised in that** the plastic film (16) has openings (10) for components (14) to be left free-standing on the printed circuit board (9).

5. Printed circuit board with protective coating according to one of Claims 1 to 4, **characterised in that** the plastic film (16) has a melting range of 120° to 170°C.

6. Process for manufacturing a printed circuit board with protective coating according to one of Claims 1 to 5, in which in a first process step (B) the plastic film (16) is formed into the geometrical shape corresponding to the area of the printed circuit board (9) to be protected, and in a following step (C) is placed on the surface of the printed circuit board, and in a final step (D) is fused onto the printed circuit board under the action of heat.

7. Process according to Claim 6, **characterised in that** the plastic film is manufactured in a process step (A) preceding the first process step (B) by pouring a molten starting material (2) to form a strip (1) on a base.

8. Process according to Claim 6, **characterised in that** plastic film is manufactured in a process step (A) preceding the first process step (B) by pouring a molten starting material (2) and drawing out a strip (1) formed between parallel rollers (5, 6).

9. Process according to Claim 7 or 8, **characterised in that** the plastic film (16) is stamped out of the strip (1).

10. Process according to Claim 7 or 8, **characterised in that** the plastic foil (16) is formed from the strip (1) by water-jet cutting, is brought to a plastic state by heating after positioning on the printed circuit board (9) and is pressed onto the electronic modules (13) by means of a silicone plug (17), so as to produce a tightly-fitting topography and to displace existing residual air, and that in a final process step the protective covering (16) is fused onto the printed circuit board (9) under the action of further heating.

## Revendications

1. Carte à circuit imprimé pour modules électroniques, comportant un revêtement protecteur en une matière thermoplastique électriquement isolante, le revêtement protecteur étant en une feuille (16) de matière plastique en une matière thermoplastique électriquement isolante, à laquelle est additionnée, pour améliorer ses propriétés de fluidité, une cire, qui permet en même temps d'interconnecter et d'effectuer des brasures dans le revêtement protecteur, la forme géométrique de la feuille en matière plastique correspondant à la surface à protéger de la carte (9) à circuit imprimé et la feuille étant fondue par effet thermique sur la carte à circuit imprimé, de sorte à recouvrir pratiquement de manière étanche à l'air et étanche à l'humidité la carte à circuit imprimé.

2. Carte à circuit imprimé à revêtement protecteur suivant la revendication 1, caractérisée en ce que la feuille (16) en matière plastique est constituée d'un mélange d'un premier constituant de polypropylène, de résine d'hydrocarbure, de polymère de styrène-butadiène, de cire de paraffine et de polyéthylène et d'un second constituant en une cire ayant une proportion considérable d'hydrocarbures à chaîne ramifiée et cycloaliphatique.

3. Carte à circuit imprimé à revêtement protecteur suivant la revendication 2, caractérisée en ce que la feuille (16) en matière plastique est constituée d'un mélange de 9 à 3 parties, de préférence de 7 parties du premier constituant et de 1 à 7 parties, de préférence de 3 parties du second constituant.

4. Carte à circuit imprimé à revêtement protecteur suivant l'une des revendications 1 à 3, caractérisée en ce que la feuille (16) en matière plastique comporte des ouvertures (10) pour des composants (14) à mettre à nu sur la carte (9) à circuit imprimé.

5. Carte à circuit imprimé à revêtement protecteur suivant l'une des revendications 1 à 4, caractérisée en ce que la feuille (16) en matière plastique a une plage de fusion comprise entre 120°C et 170°C.

6. Procédé de fabrication d'une carte à circuit imprimé à revêtement protecteur suivant l'une des revendications 1 à 5, dans lequel on donne, au cours d'une première étape opératoire (B), la forme géométrique correspondant à la surface à protéger de la carte (9) à circuit imprimé à la feuille (16) en matière plastique, puis on la dépose au cours d'une étape (C) sur la surface de la carte à circuit imprimé, et on la fait fondre au cours d'une dernière étape (D) par action de la chaleur sur la carte à circuit imprimé.

7. Procédé suivant la revendication 6, caractérisé en ce que l'on fabrique la feuille en matière plastique en une bande (1) de support formée au cours d'une étape opératoire (A) précédant la première étape opératoire (B) en déversant une matière première (2) fondue sur une couche inférieure.

8. Procédé suivant la revendication 6, caractérisé en ce que l'on fabrique la feuille de matière plastique en une bande (1) de support formée au cours d'une étape opératoire (A) précédant la première étape opératoire (B) en déversant une matière première (2) fondue et en étirant entre des cylindres (5,6) parallèles.

9. Procédé suivant la revendication 7 ou 8, caractérisé en ce que l'on découpe à la matrice la feuille (16) en matière plastique à partir de la bande (1) de support.

10. Procédé suivant la revendication 7 ou 8, caractérisé en ce que l'on forme la feuille (16) en matière plastique à partir de la bande (1) de support par découpage par jet d'eau, on la met, après positionnement sur la carte (9) à circuit imprimé, dans un état plastique par échauffement et on la presse au moyen d'un tampon (17) de silicone sur les modules (13) électroniques, de sorte à créer une topographie s'appliquant étroitement et à chasser l'air résiduel présent et on fait fondre, au cours d'une étape opératoire finale, le revêtement (16) protecteur en faisant encore agir la chaleur sur la carte (9) à circuit imprimé.
